Europäisches Patentamt

European Patent Office

Office européen des brevets

(11) Publication number: **0 145 296 B1**

# EUROPEAN PATENT SPECIFICATION

(45) Date of publication of patent specification: **08.05.91**    (51) Int. Cl.⁵: **H01S  3/10**, G11B 7/125

(21) Application number: **84307794.2**

(22) Date of filing: **12.11.84**

(54) Calibration network for a feedback lighht detector and a method of calibrating feedback output therefrom.

<table>
<tr><td>

(30) Priority: **12.12.83 US 560288**

(43) Date of publication of application:
**19.06.85 Bulletin  85/25**

(45) Publication of the grant of the patent:
**08.05.91 Bulletin  91/19**

(84) Designated Contracting States:
**DE FR GB NL**

(56) References cited:
**US-A- 4 412 331**

**ELEKTRONIK, vol. 31, no. 22, 5th November 1982, pages 89-94, Munich, DE; P. MARTEN: "Optische Sender mit Halbleiterlasern für hohe Bitraten"**

**PATENT ABSTRACTS OF JAPAN, vol. 7, no. 154 (E-185)[1299], 6th July 1983; & JP-A-58 61 691**

</td><td>

(73) Proprietor: **Laser Magnetic Storage International Company**
**4425 Arrows West Drive**
**Colorado Springs Colorado 80907(US)**

(72) Inventor: **Howard, Guy P.**
**1455 Bailey Hill Rd Apt. 12**
**Eugene Oregon 97402(US)**

(74) Representative: **Peters, Rudolf Johannes et al**
**INTERNATIONAAL OCTROOIBUREAU B.V.**
**Prof. Holstlaan 6**
**NL-5656 AA Eindhoven(NL)**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to calibration networks for feedback light detectors and methods of calibrating feedback outputs from feedback light detectors.

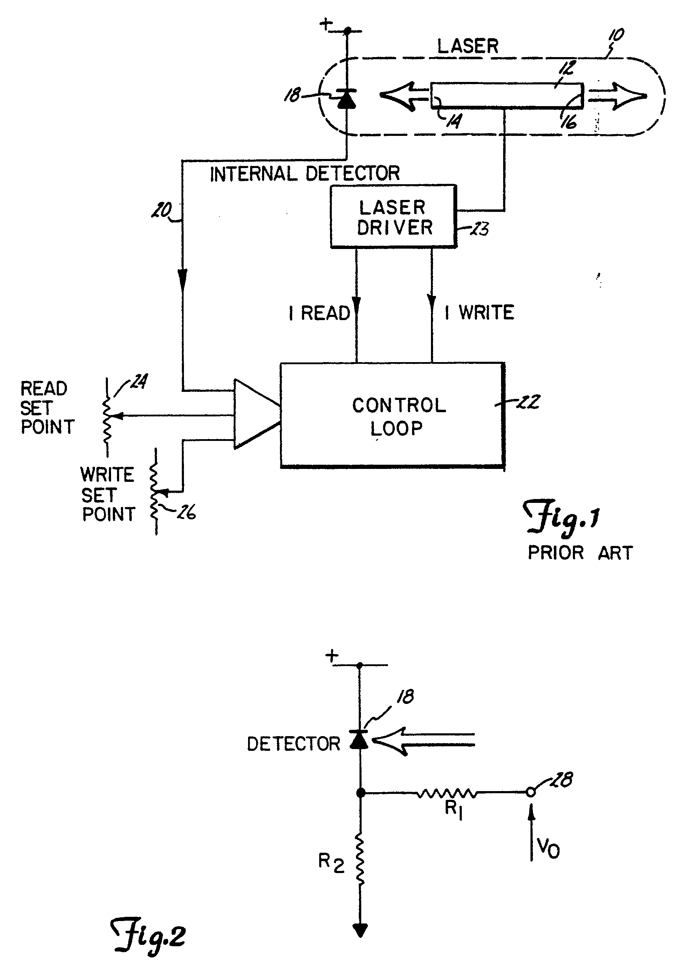

Laser diodes have many applications. One of these is in optical disk drives. An optical disk drive comprises, among other things, a feedback light detector circuit for a laser light pen 10 having a power control circuit consisting of a control loop 22 and a laser driver 23 as shown in Figure 1. The laser light pen 10 comprises a laser diode 12, and a feedback light detector 18 for the purpose of monitoring the light power output of the laser diode.

The current developed by the feedback light detector 18 varies from laser diode to laser diode due to various factors, among which are the large light beam dispersion angle from a rear facet 14 of the laser diode and mechanical tolerances in the optics of the light pen. Conventional power control circuits compensate for these variations by providing calibration potentiometers 24, 26. As the laser diode may be operated at two power levels, i.e., a read level and a write level, two corresponding potentiometers 24, 26 are required to provide a read set point and a write set point respectively.

When, as is sometimes the case, a laser diode wears out or otherwise malfunctions, the light pen is replaced as a unit. This necessitates a technician recalibrating the set points on the two potentiometers 24, 26 and this may be a time consuming task. The procedure must be repeated each time the light pen is replaced. Elimination of the recalibration step would not only save valuable time when a light pen must be replaced, but could also eliminate the need for a technician altogether.

The present invention seeks to provide a calibration network for a feedback light detector of a laser diode where calibration can be effected during manufacture to permit replacement of the combination of the laser diode and feedback light detector without recalibration of potentiometers used to set the read and write levels.

According to one aspect of the present invention there is provided a calibration network for a feedback light detector of a laser diode comprising: a first resistor which is connected between the feedback light detector and ground and which is adapted to produce a predetermined voltage at an output terminal when the feedback light detector detects that the laser diode is operating at a predetermined light power output; and a second resistor which is connected between said feedback light detector and said output terminal, and which is adapted to produce a predetermined impedance at said output terminal when said laser diode is operating at said predetermined light power output.

Said resistors may be thick film resistors.

According to another aspect of the present invention there is provided a method of calibrating feedback output from the feedback light detector of a laser diode comprising: connecting a first resistor between the feedback light detector and ground; connecting a second resistor between the feedback light detector and a output terminal; operating the laser diode to produce a predetermined light power output; adjusting the resistance of the first resistor to produce a predetermined voltage at the output terminal; and adjusting the resistance of the second resistor to produce a predetermined impedance at the output terminal.

Said resistors preferably are thick film resistors whose resistances are adjusted by trimming.

The invention is illustrated, merely by way of example, in the accompanying drawings, in which:-

Figure 1 is a schematic diagram of a conventional feedback light detector circuit and power control circuit for a laser light pen;

Figure 2 shows part of a calibration network according to the present invention for the feedback light detector and power control circuit of Figure 1;

Figure 3 is an equivalent circuit diagram of Figure 2; and

Figure 4 is another equivalent circuit diagram of Figure 2.

Throughout the drawings like parts have been designated by the same reference numerals.

Figure 2 shows a calibration network according to the present invention for a feedback light detector 18 to which two thick film resistors $R_1$, $R_2$ are connected during manufacture. The resistor $R_2$ is connected between the feedback light detector 18 and ground and the resistor $R_1$ is connected between the feedback light detector and an output terminal 28. The output terminal 28 is connected to an output line 20 connected to the control loop 22 of the power control circuit (Fig. 1) when the light pen 12 is mounted in an optical disk drive (not shown). After the light pen 12 has been nearly fully assembled, the resistors $R_1$, $R_2$ are calibrated by trimming. Trimming may be performed using conventional techniques such as air abrasion or laser scribing.

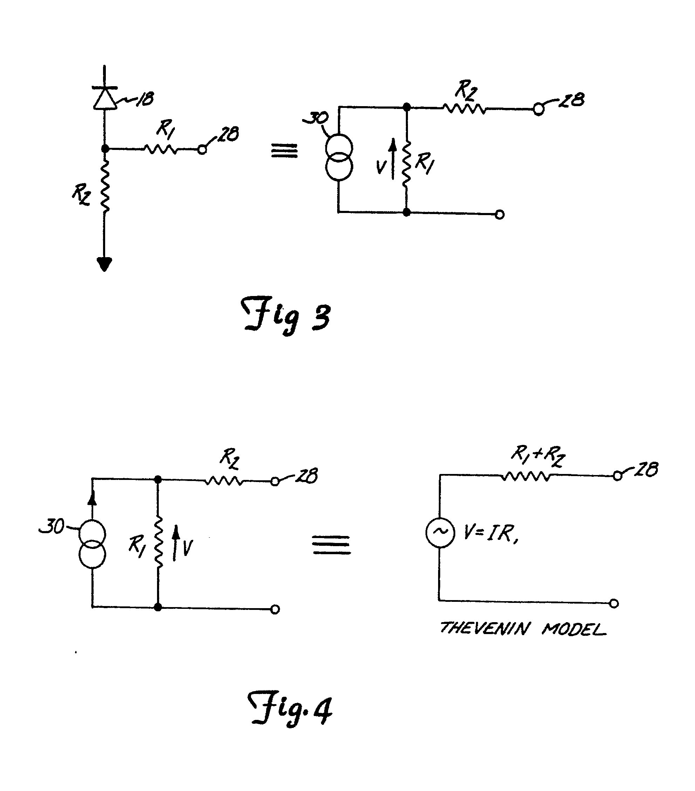

Figure 3 is an equivalent circuit diagram of the calibration network of Figure 2. The feedback light detector 18 is represented as a current source 30 producing a current I. The voltage, as measured at the output terminal 28, is equivalent to a voltage V developed across the resistor $R_1$: $V = IR_1$.

The equivalent circuit diagram of Figure 3 can be modelled using a Thevenin voltage equivalent circuit shown in Figure 4. There the output impedance at the output terminal 28 can be seen to be the sum of the resistance values of the resistors $R_1$, $R_2$.

The calibration network of Figure 2 is calibrated as follows: first, power is applied to the laser diode 12 to produce a predetermined light power output from a front facet 16, which may be measured using calibrated light detecting apparatus (not shown). The resulting current from the feedback light detector 18 flows through the resistor $R_1$ to ground. The voltage at the output terminal 28 is the voltage at the junction of the resistors $R_1$, $R_2$. This voltage is measured and the resistor $R_2$ is then trimmed to produce a predetermined voltage $V_0$ at the output terminal 28. Next, the resistor $R_1$ is trimmed to produce a predetermined impedance output, $C = R_1 + R_2$. C may, for example, be 50, 75 or 300 ohms, the resistance of typical transmission lines such as the output line 20, a coaxial cable, a twisted pair cable, etc. This latter step is necessary due to the high frequency at which the laser diode 12 is typically modulated in an optical disk drive. Unless the impedence at the output terminal 28 is controlled, the current of the output terminal can be expected to vary greatly between the unmodulated read level and the modulated write level.

## Claims

1. A calibration network for a feedback light detector (18) of a laser diode (12) comprising: a first resistor ($R_2$) which is connected between the feedback light detector (18) and ground and which is adapted to produce a predetermined voltage ($V_0$) at an output terminal (28) when the feedback light detector (18) detects that the laser diode (12) is operating at a predetermined light power output; and a second resistor ($R_1$) which is connected between said feedback light detector (18) and said output terminal (28), and which is adapted to produce a predetermined impedance (C) at said output terminal when said laser diode is operating at said predetermined light power output.

2. A calibration network as claimed in claim 1 characterised in that said resistors ($R_1$,$R_2$) are thick film resistors.

3. A calibration network as claimed in claim 1 or 2 characterised by being in combination with the laser diode (12).

4. A method of calibrating feedback output from the feedback light detector of a laser diode comprising: connecting a first resistor ($R_2$) between the feedback light detector (18) and ground; connecting a second resistor ($R_1$) between the feedback light detector (18) and an output terminal (28); operating the laser diode (12) to produce a predetermined light power output; adjusting the resistance of the first resistor ($R_2$) to produce a predetermined voltage ($V_0$) at the output terminal (28); and adjusting the resistance of the second resistor ($R_1$) to produce a predetermined impedence (C) at the output terminal.

5. A method as claimed in claim 3 in which said resistors ($R_1$,$R_2$)are thick film resistors whose resistances are adjusted by trimming.

## Revendications

1. Réseau d'étalonnage pour un détecteur de lumière à réaction (18) d'une diode laser (12) comportant: une première résistance ($R_2$) raccordée entre le détecteur de lumière à réaction (18) et la masse et qui est agencée pour délivrer une tension prédéterminée ($V_0$) sur une borne de sortie (28) lorsque le détecteur de lumière à réaction (18) détecte que la diode laser (12) fonctionne à une intensité lumineuse de sortie prédéterminée, et une deuxième résistance ($R_1$) raccordée entre ledit détecteur de lumière à réaction (18) et ladite borne de sortie (28) et qui est agencée de façon à fournir une impédance prédéterminée (C) sur ladite borne de sortie lorsque ladite diode laser fonctionne à ladite intensité lumineuse de sortie prédéterminée.

2. Réseau d'étalonnage selon la revendication 1, caractérisé en ce que lesdites résistances ($R_1$, $R_2$) sont des résistances à couche mince.

3. Réseau d'étalonnage selon la revendication 1 ou 2, caractérisé en ce qu'il est combiné avec la diode laser (12).

4. Procédé d'étalonnage du signal de sortie de réaction du détecteur de lumière à réaction d'une diode laser consistant à: raccorder une première résistance ($R_2$) entre le détecteur de lumière à réaction (18) et la masse, à raccorder une deuxième résistance ($R_1$) entre le détecteur de lumière à réaction (18) et une borne de sortie (28), à faire fonctionner la diode laser (12) de façon qu'elle fournisse une intensité lumineuse de sortie prédéterminée, à ajuster la valeur de la première résistance ($R_2$) de façon qu'elle fournisse une tension prédéterminée (V₀) sur la borne de sortie (28), et à ajuster la valeur de la deuxième résistance (R₁) de façon qu'elle fournisse une impédance prédéterminée (C) sur la borne de sortie.

5. Procédé selon la revendication 3, suivant lequel lesdites résistances (R₁, R₂) sont des résistances à couche épaisse dont les valeurs sont réglées par ajustement d'appoint.

## Ansprüche

1. Eichnetzwerk für einen Rückkoppel-Lichtdetektor (18) einer Laserdiode (12) mit einem ersten Widerstand (R₂), der zwischen dem Rückkoppel-Lichtdetektor (18) und Masse angeschlossen ist und zum Erzeugen einer vorgegebenen Spannung (V₀) an einer Ausgangsklemme (28) dient, wenn der Rückkoppel-Lichtdetektor (18) den Betrieb der Laserdiode (12) mit einer vorgegebenen Lichtleistung detektiert, und mit einem zweiten Widerstand (R₁), der zwischen dem Rückkoppel-Lichtdetektor (18) und der Ausgangsklemme (28) angeschlossen ist und zum Erzeugen einer vorgegebenen Impedanz (C) an dieser Ausgangsklemme dient, wenn die Laserdiode (12) mit der vorgegebenen Lichtleistung arbeitet.

2. Eichnetzwerk nach Anspruch 1, dadurch gekennzeichnet, daß die Widerstände (R₁, R₂) Dickschichtwiderstände sind.

3. Eichnetzwerk nach Anspruch 1 oder 2, dadurch gekennzeichnet, daß es eine Kombination mit der Laserdiode (12) bildet.

4. Verfahren zum Eichen der Rückkopplungsleistung aus dem Rückkopplungs-Lichtdetektor einer Laserdiode, das folgende Schritte umfaßt:
   Verbinden eines ersten Widerstandes (R₂) zwischen dem Rückkoppel-Lichtdetektor (18) und Masse;
   Verbinden eines zweiten Widerstandes (R₁) zwischen dem Rückkoppel-Lichtdetektor (18) und einer Ausgangsklemme (28); Betreiben der Laserdiode (12) zur Lieferung einer vorgegebenen Lichtleistung;
   Einstellen des Widerstandswerts des ersten Widerstandes (R₂) zum Anlegen einer vorgegebenen Spannung (V₀) an die Ausgangsklemme (28); und
   Einstellen des Widerstandswerts des zweiten Widerstandes (R₁) zum Erzeugen einer vorgegebenen Impedanz (C) an der Ausgangsklemme.

5. Verfahren nach Anspruch 3, worin die Widerstände (R₁, R₂) Dickschichtwiderstände sind, deren Widerstandswerte durch Feinabgleich eingestellt werden.

*Fig.1*
PRIOR ART

*Fig.2*

Fig 3

THEVENIN MODEL

Fig. 4